(19) Europäisches Patentamt
European Patent Office
Office européen des brevets

(11) **EP 0 718 418 B1**

(12) **EUROPÄISCHE PATENTSCHRIFT**

(45) Veröffentlichungstag und Bekanntmachung des Hinweises auf die Patenterteilung:
**14.01.1998 Patentblatt 1998/03**

(51) Int Cl.6: **C23C 16/02**, C23C 16/50, C23C 16/52

(21) Anmeldenummer: **95114298.3**

(22) Anmeldetag: **12.09.1995**

(54) **Verfahren zur Herstellung einer Gradientenschicht**

Process for the production of a graded layer

Procédé de production d'une couche à gradient

(84) Benannte Vertragsstaaten:
**AT BE CH DE ES FR GB GR IT LI NL SE**

(30) Priorität: **20.12.1994 DE 4445427**

(43) Veröffentlichungstag der Anmeldung:
**26.06.1996 Patentblatt 1996/26**

(73) Patentinhaber:
• **Schott Glaswerke**
**55122 Mainz (DE)**
Benannte Vertragsstaaten:
**BE CH DE ES FR GR IT LI NL SE AT**
• **CARL-ZEISS-STIFTUNG**
**trading as SCHOTT GLASWERKE**
**55122 Mainz (DE)**
Benannte Vertragsstaaten:
**GB**

(72) Erfinder:
• **Otto, Jürgen, Dr.**
**D-55128 Mainz (DE)**
• **Paquet, Volker**
**D-55126 Mainz (DE)**
• **Segner, Johannes, Dr.**
**D-55442 Stromberg (DE)**

(56) Entgegenhaltungen:
**EP-A- 0 177 517**      **EP-A- 0 370 925**
**EP-A- 0 472 465**      **US-A- 5 217 749**
**US-A- 5 344 792**

• **JOURNAL OF THE CERAMIC SOCIETY OF JAPAN, INTERNATIONAL EDITION, Bd. 99, Nr. 10, 1. Oktober 1991 Seiten 872-879, XP 000275441 KERSTEN R T ET AL 'THICK COATINGS OF DOPED SYNTHETIC SILICA GLASS BY PLASMA IMPULSE CVD'**

## Beschreibung

Die Erfindung betrifft ein Plasma-CVD-Verfahren zur Herstellung einer Gradientenschicht, bei welchem der Schichtgradient in Schichtwachstumsrichtung durch Änderung wenigstens eines Plasmaleistungsparameters während des Beschichtungsprozesses erzeugt wird.

Aus EP 0177517 B1 ist ein Plasma-CVD-Verfahren (Plasma-**C**hemical-**V**apor-**D**eposition) zum Aufbringen dünner transparenter Schichten auf die Oberflächen optischer Elemente bekannt. Es handelt sich hierbei um ein Verfahren zur Herstellung gradientenförmiger Kratzschutzschichten auf - insbesondere - Kunststoffsubstraten, bei dem durch kontinuierliche Steigerung des Anteils einer härtesteigernden Komponente zu einem organischen Beschichtungsgas (vorzugsweise $O_2$ zu einer Si-organischen Verbindung) die Zusammensetzung der Schicht so geändert wird, daß die Substratseite der Schicht eine gute Haftfestigkeit und die Luftseite eine hohe Härte aufweist.

Die Änderung der Schichtzusammensetzung besteht dabei im wesentlichen in einem kontinuierlichen Übergang organisch -> anorganisch in Schichtwachstumsrichtung.

Dieses Verfahren hat den Nachteil, daß sich zeitlich veränderliche Massenflüsse zur Herstellung von in der Zusammensetzung gradientenförmigen Schichten nur mit geringerer Prozeßstabilität als zeitlich konstante Massenflüsse einstellen lassen. Üblicherweise verwendete Massenflußregler sind mit Einstellzeiten von mindestens 0,5 sec sehr träge und deshalb zur Herstellung von Schichten mit steilen Gradienten (z.B. von 1 % Konzentrationsänderung pro nm Schichtdicke) und/oder sehr dünnen Gradientenschichten (z.B. eine optische Lambdaviertelschicht von etwa 85 nm), bei welchen bei üblichen Abscheideraten von 500 nm/min Konzentrationsänderungen im sec-Bereich oder kleiner erfolgen müssen, ungeeignet.

Die Herstellung solcher Schichten wäre zwar prinzipiell durch eine entsprechende Erniedrigung der Beschichtungsrate möglich; diese bedingt jedoch längere Beschichtungszeiten und Spezialregler für niedrige Massenflüsse, die sehr kostspielig sind. Diese Vorgehensweise wäre deshalb wirtschaftlich sehr nachteilig. Prinzipiell wäre es z. B. möglich, zur Erzielung niedriger Beschichtungsraten das Beschichtungsgas entsprechend zu verdünnen. Hieraus kann jedoch eine ungewünschte Beeinflussung anderer Schichteigenschaften wie z. B. der Brechzahl (s. B. J. Electrochem Soc, 141, 3234-37, 1994) resultieren.

Aus M. R. Wertheimer u.a., Thin Solid Films 115, 1984, S. 109, ist bekannt, daß bei Plasmapolymerisation von HMDSO mit zunehmender Leistung und/oder Substrattemperatur sich die Struktur der abgeschiedenen Schicht ändert, der Gehalt an organischen Bestandteilen deutlich abnimmt, die Ätzrate der Schicht zunimmt und mit zunehmender Substrattemperatur die Brechzahl anwächst.

Dieser Effekt wird in US-PS 5217749, welche die Grundlage zum Oberbegriff des Anspruchs 1 bildet, zur Herstellung einer Brechzahl-Gradientenschicht ausgenutzt. Nach der Druckschrift werden mit einem PCVD-Verfahren Schichten aus dem Monomerdampf einer organischen Verbindung polymerisiert, wobei allein durch kontinuierliche Änderung der Prozeßleistung während des Beschichtungsprozesses ein Brechzahlgradient in Schichtwachstumsrichtung erzeugt wird.

Bei diesem Verfahren tragen jedoch mehrere Mechanismen dazu bei, daß eine gezielte Änderung der Schichtzusammensetzung problematisch wird:

Zum einen erfolgt die Herstellung der Schichten aus Beschichtungsgasen, in denen Frischgas und Restgas aus der vorangegangenen Reaktion undefiniert miteinander vermischt sind. Dies hat zur Folge, daß bei Änderung irgendeines Beschichtungsparameters die Zusammensetzung der entstehenden Schicht und davon abhängige Schichteigenschaften sich undefiniert ändern können. Zum anderen steigt bei Erhöhung der Leistung die Substrattemperatur an, wodurch zur gewollten Änderung des Parameters Leistung die ungewollte Änderung des Parameters Substrattemperatur kommt. Weiterhin erfolgt in Richtung der Strömung des zugeführten Frischgases über dem Substrat eine Verarmung an reaktionsfähigen Species, so daß die Schichteigenschaften in dieser Richtung unterschiedlich sind. Der zweite Mechanismus hat außerdem zur Folge, daß wärmeempfindliche Substrate nicht beschichtet werden können.

Außerdem ist nachteilig, daß die Beschichtungsrate von etwa 4 nm/min sehr klein ist und bei dem angegebenen Druck von 60 mTorr und der vorgegebenen RF-Leistung durch Erhöhung des Massenflusses des Beschichtungsgases vermutlich höchstens auf Kosten der lateralen Uniformität erhöht werden kann.

Aufgabe der Erfindung ist ein Verfahren anzugeben, mit dem Schichtgradienten auch bei sehr dünnen Schichten mit hoher Genauigkeit einstellbar sind. Darüber hinaus soll das Verfahren wirtschaftlich und schnell arbeiten.

Diese Aufgabe wird bei einem Verfahren der eingangs genannten Art dadurch gelöst, daß die Plasmaleistung gepulst zugeführt wird (Plasma-Impuls-CVD-Verfahren) und der Schichtgradient in Schichtwachstumsrichtung durch Änderung der Plasmaleistungsparameter Impulshöhe, Impulsdauer und/oder Impulspause während des Beschichtungsprozesses eingestellt wird.

Plasma-Impuls-CVD-Verfahren sind bekannt und beispielsweise in Journal of the ceramic society of Japan, 99 (10), 872 - 879 (1991) beschrieben. Bei diesen Verfahren wird in der Regel bei kontinuierlichem Fluß der Beschichtungsgase die das Plasma anregende elektromagnetische Strahlung gepulst zugeführt, wobei sich bei jedem Impuls eine dünne Schicht (typisch ≈ 1 nm) auf das Substrat niederschlägt. Dadurch, daß jedem Leistungsimpuls eine Impulspause folgt, können selbst nicht-temperaturstabile Substrate mit während eines Impulses hohen Leistungen beaufschlagt werden. Hierdurch sind insbesondere hohe Beschichtungsraten ohne nennenswerte Temperaturbelastung des Substrates möglich.

Es hat sich in völlig überraschender Weise gezeigt, daß bei Anwendung eines solchen Plasma-Impuls-CVD-Verfahrens nicht, wie aus dem Stand der Technik bei kontinuierlichen Verfahren bekannt, eine Änderung der zur Erzeugung und Aufrechterhaltung des Plasmas zugeführten Leistung ausschlaggebend für die Herstellung einer Gradientenschicht ist, sondern im wesentlichen die Höhe und Dauer der Leistungsimpulse sowie die Dauer der Impulspause. Die zugeführte mittlere Leistung, die sich bei einem Plasma-Impuls-Verfahren wie folgt berechnet:

$$= \frac{\text{Impulshöhe x Impulsdauer}}{\text{Impulspause} + \text{Impulsdauer}}$$

liegt auch bei dem erfindungsgemäßen Verfahren in derselben Größenordnung wie die bei einem üblichen kontinuierlichen Verfahren eingestellte Leistung. Sie kann sogar niedriger sein. Dies ist insbesondere bei der Beschichtung wärmeempfindlicher Kunststoffe von Bedeutung oder wenn über die Substrattemperatur Schichteigenschaften wie z. B. Härte oder Hydrophilie beeinflußt werden sollen. Die mittlere Leistung läßt sich bei einem Plasma-Impuls-CVD-Verfahren in einfacher Weise über die Länge der Impulspause und/oder Impulsdauer und/oder den Betrag der Impulshöhe einstellen.

Die Impulshöhe ist bei einem Plasma-Impuls-CVD-Verfahren ein Leistungsmaß. Sie entspricht der Impulsleistung, d.h. dem Produkt aus Generatorspannung und Generatorstrom während der Impulsdauer. Der Anteil der Leistung, der tatsächlich ins Plasma eingekoppelt wird, hängt von einer Reihe von Parametern, z. B. der Dimensionierung des die Impulse abgebenden Bauteils und des Reaktors, ab.

Je nach Impulshöhe werden

a) ab einem Schwellwert, der für jedes Gas charakteristisch ist, unterschiedliche Anregungen und Reaktionen im Plasma erzeugt
b) unterschiedliche Dicken der Plasmazone eingestellt.

Bei Anwendung des erfindungsgemäßen PICVD-Verfahrens (geeignete Wahl der Impulspause sorgt für immer gleiche Gaszusammensetzung vor jedem Impuls, beispielsweise durch saubere Trennung des Abgases vom Frischgas) können von Impuls zu Impuls durch entsprechende Wahl der Impulshöhe gezielt lagenweise Elementarschichten (Monolagen) unterschiedlicher Zusammensetzung abgeschieden werden. Beim üblichen PCVD-Verfahren ist ähnliches nicht möglich.

Während der Dauer eines Impulses (Impulsdauer) laufen im Plasmabereich

- je nach Impulslänge - nacheinander folgende Vorgänge ab:
- Reaktion
- Abscheidung
- Nachbehandlung.

Die Nachbehandlung kann bewirken:

- Substraterwärmung
- Plasmaätzung
- Abspaltung von Schichtkomponenten
- Verfestigung der Schicht
- Oxidation der Schichtoberfläche
- Implantation oder Anlagerung von Gasen des Plasmas in die Schicht.

Es ist zu vermuten, daß die erfindungsgemäße Änderung der Impulsdauer während des Beschichtungsprozesses insbesondere in die Nachbehandlung eingreift und damit die unterschiedlichen Schichteigenschaften in den Elementarschichten durch eine mehr oder weniger intensive Nachbehandlung bewirkt werden.

Die Impulspause bestimmt einmal den Temperaturverlauf des Substrates bei der Beschichtung; zum anderen den Anteil von Abgasmolekülen aus dem vorangegangenen Plasmaimpuls im aktuellen Beschichtungsgas, wenn die Impulspause bewußt kürzer gemacht wird, als zur sauberen Trennung von Frischgas und Abgas erforderlich ist. Der Einfluß auf die Schichtzusammensetzung bzw. -eigenschaften ist bei der Impulspause etwas schwächer ausgebildet als bei Impulshöhe und -dauer.

Wichtig ist hier noch, daß die Impulsdauer im Vergleich zur Strömungsgeschwindigkeit des Gases so gewählt ist, daß während des Impulses das Gas als ruhend angesehen werden kann.

Die nachfolgenden bevorzugten Bereiche für die Leistungsparameter wurden experimentell ermittelt:

| Impulsdauer | 0,01 - 10 msec |
|---|---|
| Impulspause | 1 - 1000 msec |
| Impulshöhe | 10 - 100000 W |

Je nach Schichtbildner ist die Zündfeldstärke unterschiedlich, so daß die Mindestimpulshöhe gasspezifisch ist.

Mit Hilfe des erfindungsgemäßen Verfahrens lassen sich Schichten mit einem Zusammensetzungs- und/oder Strukturgradienten herstellen. Über diese Gradienten können bestimmte physikalische und/oder chemische Eigenschaften, wie z. B. Brechzahl, Härte, innere Spannung, Hydrophilie bzw. allgemeine Benetzbarkeit, E-Modul usw. gezielt variiert werden. Es lassen sich insbesondere auch Gradientenschichten mit konstanter Zusammensetzung, aber veränderlichen physikalischen/chemischen Eigenschaften herstellen: Ein Beispiel hierfür ist die Herstellung einer $TiO_2$-Schicht aus $TiCl_4 + O_2$. Für die Herstellung einer $TiO_2$-Schicht mit Eigenschaften, die dem des Massivmaterials sehr nahekommen, ist eine bestimmte Impulshöhe und Impulsdauer nötig. Mit Verkürzung der Impulsdauer wird die $TiO_2$-Schicht in Schichtwachstumsrichtung zunehmend poröser und die Brechzahl (und Härte) niedriger, obwohl die Schichtzusammensetzung über die Schichtdicke konstant ist.

Es wurde insbesondere gefunden, daß sich durch eine Verlängerung/Vergrößerung von Impulsdauer und Impulshöhe, einzeln oder kombiniert, der organische Gehalt, d. h. der Gehalt an Kohlenwasserstoff, einer Schicht, die aus einem metallorganischen, speziell Si-organischen, Schichtbildner hergestellt wird, vermindern läßt.

Die Erfindung erlaubt also, mit einem Beschichtungsgas, das einen metallorganischen, insbesondere Si-organischen, Schichtbildner und ggf. zusätzlich noch Sauerstoff oder Stickstoff oder ein Gas, das Sauerstoff oder Stickstoff in einem Plasma abspaltet, enthält, ohne Änderung der Gaszusammensetzung nur durch Vorgabe von Eigenschaften des Impulses (Dauer, Höhe) bzw. über die Dauer der Impulspause den organischen Gehalt der entstehenden Schicht und die von diesem organischem Gehalt abhängigen Eigenschaften, zu variieren.

Aus einem Reaktionsgemisch bestehend aus HMDSO + 15 % $O_2$ wird beispielsweise bei großer Impulsdauer ($\geq$ 1 ms) eine praktisch anorganische und bei kleiner Impulsdauer ($\leq$ 0,1 ms) eine praktisch organische Schicht abgeschieden.

Das erfindungsgemäße Verfahren ist damit insbesondere zur Herstellung von Kratzschutzschichten auf Kunststoffsubstraten (z.B. für optische Anwendungen wie Brillengläser) geeignet. Solche Kratzschutzschichten weisen vorteilhafterweise auf der Substratseite einen hohen Gehalt an organischem Material auf, während in Schichtwachstumsrichtungen ein Übergang organisch --> anorganisch erfolgt. Solche Kratzschutzschichten z. B. für Brillengläser sind an sich bekannt und u.a. in EP 0 177 517 beschrieben.

Zur Herstellung einer Kratzschutzbeschichtung auf Brillengläsern mit Hilfe des erfindungsgemäßen Verfahrens eignen sich besonders Si-organische Verbindungen wie z.B. Hexamethylsiloxan (HMDSO), Hexamethylsilazan (HMDS), Tetraethoxysilan (TEOS), Tetramethoxysilan, Tetramethylsilan, da die harte Seite der Beschichtung - falls der Schichtbildner nicht ausreichend viel Sauerstoffatome enthält unter Zugabe von Sauerstoff in das Beschichtungsgas - quarzähnlich gemacht werden kann.

Die Zugabe von Sauerstoff, Stickstoff oder einem Gas, das Sauerstoff oder Stickstoff in Plasma abspaltet, dient allgemein dazu, durch einen reaktiven Behandlungsschritt eine Sauerstoff- oder Stickstoff-Verbindung zu schaffen oder die Zahl der Sauerstoff- oder Stickstoffatome in einer Schicht zu erhöhen. Soll die Härtesteigerung beispielsweise durch Si-Nitrid- oder -Oxinitridbildung erfolgen, ist analog die Zugabe von Stickstoff oder Ammoniak in das Beschichtungsgas erforderlich. Entsprechend lassen sich auch organische Ti-, Al-Verbindungen und andere metallorganischen Verbindungen zur Herstellung von Gradientenschichten einsetzen.

Das erfindungsgemäße Verfahren eignet sich auch besonders zur Herstellung sog. Haftvermittlerschichten.

Hierbei handelt es sich um Hilfsschichten, die gebraucht werden, wenn Funktionsschichten mit den Substraten keine feste Bindung eingehen und sich bei Belastung ablösen. Dies geschieht oft, wenn Substrat und Funktionsschicht artfremd sind, z. B. bei den Kombinationen organisch/anorganisch oder metallisch/oxidisch.

In solchen Fällen läßt sich eine Bindung zwischen Substrat und Funktionsschicht durch eine sogenannte Haftvermittlerschicht erreichen, die typischerweise sowohl zur Funktionsschicht als auch zum Substrat artverwandt ist, die, um beim o. g. 1. Beispiel zu bleiben, aus einem anorganischen Material mit organischem Gehalt bestehen kann.

Eine bessere Lösung besteht darin, die Haftvermittlerschicht als Gradientenschicht auszubilden, die auf der (z. B. organischen) Substratseite vollständig oder zu einem hohen Anteil organisch ist und deren Zusammensetzung sich kontinuierlich so ändert, daß sie auf der Funktionsschichtseite vollständig oder zu einem hohen Anteil anorganisch ist. Diese Lösung ist deshalb besser, weil die Grenzflächen der Haftvermittlerschicht zu Substrat und Funktionsschicht praktisch artgleich gemacht werden können.

Das erfindungsgemäße Verfahren ist ebenso auf organische Schichtbildner (z.B. Äthylen) ohne Metallkomponente anwendbar. Dann bewirkt eine Vergrößerung von Impulsdauer und Impulshöhe, einzeln oder kombiniert, eine stärkere Vernetzung und/oder eine Verkleinerung des Wasserstoffgehaltes. Reduzierter Wasserstoffgehalt bedeutet größere Härte und höhere Brechzahl.

Aus Methan wurde in einem Beschichtungsversuch beispielsweise bei kleiner Impulshöhe von 400 W eine weitgehend durchsichtige weiche Polymerschicht mit einer Brechzahl von 1,47 erzeugt und bei einer Impulshöhe von 1100 W eine braune, härtere Schicht mit einer Brechzahl von 1,58. Die übrigen Beschichtungsparameter waren

| Massenfluß $CH_4$ | 25 sccm |
|---|---|
| Impulspause | 40 ms |
| Impulsdauer | 1ms |
| Anregungsfrequenz | 2,45 GHz |
| Substrattemperatur (Mikrowellen-PICVD-Verfahren) | 50 °C |

Da nach dem erfindungsgemäßen Verfahren Schichtzusammensetzungen bzw. -strukturen praktisch trägheitslos nur durch Schalten von elektrischen Federn eingestellt werden und nicht über vergleichsweise langsame, durch Massenflußänderungen bewirkte Konzentrationsänderungen des Beschichtungsgases, kann dies mit sehr großer Geschwindigkeit erfolgen. Daneben ist es aber durchaus möglich, einen zusätzlichen Effekt durch zusätzliche Änderung der Beschichtungsgaszusammensetzung zu erzielen. Elektronisch bereitet es einerseits keine Schwierigkeiten, von Impuls zu Impuls dessen Form zu ändern; andererseits lassen sich in einem typischen Mikrowellen-PICVD-Verfahren mit beispielsweise HMDSO als Schichtbildner pro Impuls 0,1 bis 1 nm dicke Schichten niedergeschlagen, was bei einer Impulspause von beispielsweise 20 ms eine Beschichtungsrate von bis zu 3000 nm/min ergibt, so daß bei hoher Beschichtungsrate sowohl dünne (z.B. optische Lambdaviertelschichten) als auch dicke im Kohlenwasserstoffgehalt gradientenförmige Schichten mit sehr hoher Ortsauflösung in Schichtaufwachstumsrichtung (Monolagenbereich) herstellen lassen.

Der PICVD-Prozeß läßt sich mit Wechselspannungsimpulsen einer Frequenz zwischen etwa 50 kHz und 300 GHz durchführen. Besonders geeignet wegen der hohen Beschichtungsrate und der Möglichkeit, in einem vergleichsweise breiten Druckbereich (0,001 bis etwa 10 mbar) zu arbeiten, sind Mikrowellenfrequenzen; unter diesen ist die 2,45 GHz-Frequenz bevorzugt, weil die entsprechenden Mikrowellenbauteile leicht zu beschaffen und preisgünstig sind. Das Impulsverfahren bietet als weiteren Vorteil die Möglichkeit, den Impuls selbst zu formen und dadurch Eigenschaften der durch einen einzigen Plasmaimpuls abgeschiedenen dünnen Schicht in Schichtwachstumsrichtung noch weiter zu beeinflussen. Bei einem Druck von 0,1 - 2 mbar, einer Anregungsfrequenz von 2,45 GHz haben sich insbesondere Impulsdauern zwischen 0,1 und 2 ms und Impulspausen zwischen 5 und 500 ms als geeignet zur Herstellung der erfindungsgemäßen Schichttypen erwiesen. Wenn die Reaktionszeiten im Plasma sehr klein sind, können Impulsdauern von 0,01 ms sinnvoll sein; die Verwendung so kurzer Impulse ist jedoch oft durch apparative Begrenzungen (Impulsanstiegszeit) beschränkt. Der empfohlene Bereich für die Impulshöhe läßt sich nicht in Zahlen angeben; der Minimalwert ist der Wert, bei dem gerade noch bei dem betreffenden Beschichtungsgas und den übrigen Prozeßparametern die Entladung gezündet werden kann, der Maximalwert ist gegeben durch die Leistungsfähigkeit des gerade verwendeten Impulsgenerators.

Zur Herstellung einer Gradientenschicht wird man in der Regel so vorgehen, daß man in einer Vorversuchsreihe die Abhängigkeit der Schichteigenschaften bzw. -zusammensetzungen von Impulsdauer, -höhe und -pause ermittelt und bei der eigentlichen Herstellung der Gradientenschicht diese Parameter so steuert, daß in Schichtwachstumsrichtung der gewünschte Gradient entsteht. Die Genauigkeit, mit der der Gradient vorher festgelegt werden muß, richtet sich nach den Anforderungen an die Schicht. Es ist mit dem erfindungsgemäßen Verfahren ohne Schwierigkeiten möglich, beispielsweise die Zusammensetzung der Schicht auf dem Substrat in Schichtwachstumgsrichtung von Monolage zu Monolage zu ändern.

Nachfolgend wird die Erfindung an Hand von Ausführungsbeispielen näher erläutert:

Das Beschichtungsgas kann, wie das nachfolgende Ausführungsbeispiel zeigt, auch mehrere Schichtbildner (z. B. 5) enthalten. Werden während des Beschichtungsprozesses die Impulsparameter geeignet geändert, werden die Anteile der Schichtbildner in der niedergeschlagenen Schicht ebenfalls geändert. Bei Änderung (Anwachsen) der Impulsdauer beispielsweise bauen sich zunächst vorzugsweise die Schichtbildner mit der kürzesten Reaktionszeit in die Schicht ein.

Ausführungsbeispiele:

1. Gasgemisch aus $TiCl_4$ + HMDSO + $O_2$:

| Massenfluß TiCl$_4$ | 5 sccm |
|---|---|
| Massenfluß HMDSO | 20 sccm |
| Massenfluß O$_2$ | 75 sccm |
| Impulspause | 50 ms |
| Frequenz | 2,45 GHz |
| Substrattemperatur | 60 °C |
| Druck | 0,5 mbar |

Bei kurzer Impulsdauer (etwa 0,3 ms) besteht die Schicht aus TiO$_a$C$_b$H$_c$Si$_d$, bei größerer (etwa 1,1 ms) aus TiO$_e$C$_f$H$_g$Si$_h$, wobei a>e, b>f .... ist.

2. Herstellung einer in Härte, Hydrophilie und innerer Spannung gradientenförmigen SiO$_2$-Schicht durch Variation der Impulsdauer.

Eine Substratplatte aus Glas wurde 5 min. unter Verwendung eines Mikrowellenplasma-Impuls-CVD-Verfahrens beschichtet, wobei ein Beschichtungsgas aus Sauerstoff und Hexamethyldisiloxan (HMDSO) verwendet wurde.

| O$_2$-Massenfluß | 100 sccm |
|---|---|
| HMDSO-Massenfluß | 12,5 sccm |
| Impulspause | 90 ms |
| Impulsdauer | 0,5 bis 1,5 ms zeitlich linear wachsend |
| Impulshöhe | 45 % des Maximalwertes eines 6 kW-Magnetrons |
| Prozeßdruck | 0,6 mbar |
| Substrattemperatur | 70 °C und 140 °C |
| Beschichtungsdauer | 5 min. |
| Schichtdicke | 2100 und 1800 nm (für 70 und 140 °C) |

Ergebnis:

| | Impulsdauer ms | Innere Spannung MPa | Hydrophilie*) | Härte **) |
|---|---|---|---|---|
| **70 °C** Beginn Ende des Beschichtungsprozesses | 0,5 | - 22,5 | 9,6 | 5 |
| | 1,5 | + 1,0 | 17,3 | 3 |
| **140 °C** Beginn Ende des Beschichtungsprozesses | 0,5 | - 3,5 | 10,3 | 4 |
| | 1,5 | - 29,1 | 10,0 | 2 |

*) Meßzahl für Hydrophilie ist die Benetzungsfläche eines Wassertropfens auf der abgeschiedenen Schicht (in mm$^2$)

**) gemessen nach DIN 58 196 T4

Bei diesen Ausführungsbeispielen wurde die Temperatur jeweils auf ± 10 ° genau eingehalten, während nach dem Stand der Technik Temperaturänderungen von > 100 ° erforderlich sind, um nennenswerte Zusammensetzungs- bzw. Eigenschaftsänderungen zu erreichen.

3. Herstellung einer in der Härte gradientenförmigen Schicht durch Variation von Impulsleistung und Impulspause.

Eine Substratplatte aus CR39 wurde 5 min mit einem Mikrowellen-PICVD-Verfahren beschichtet mit einer Beschichtungsgasmischung aus 80 sccm Sauerstoff und 12 sccm HMDSO.

| O$_2$-Massenfluß | 80 sccm |
|---|---|
| HMDSO-Massenfluß | 12 sccm |
| Impulshöhe | 20 % bis 50 % des Maximalwertes eines 6 kW-Magnetrons zeitlich linear wachsend |
| Impulspause | 20 ms bis 75 ms zeitlich linear wachsend |
| Impulsdauer | 1 ms |
| Prozeßdruck | 0,5 mbar |
| Substrattemperatur | 40 °C |

| Ergebnis: | Härte *) |
|---|---|
| Schichtbeginn | 5 |
| Schichtende | 2-3 |

*) gemessen nach DIN 58 196 T4

4. Herstellung einer Haftvermittlerschicht für einen optischen Sensor.

Eine Substratplatte aus Polykarbonat wurde nach dem PICVD-Verfahren gemäß DE-PS 42 28 853 mit einer 200 nm dicken wellenleitenden $TiO_2$-Schicht belegt. Bei der Weiterverarbeitung zu einem optischen Sensor muß das beschichtete Substrat mit alkalischen und sauren Lösungen behandelt werden. Um die Schichthaftung zu erhöhen, wurde zwischen Substrat und wellenleitender Schicht eine als Haftvermittlerschicht ausgebildete Zwischenschicht angeordnet. Die Herstellungsparameter der Haftvermittlerschicht waren:

| Gesamtmassenfluß: $O_2$ + HMDSO: | 100 sccm |
|---|---|
| HMDSO-Anteil: | 40 sccm |
| Impulshöhe | 40 % des Maximalwertes eines 6kw - Magnetrons |
| Impulspause | 30 ms |
| Impulsdauer | zeitlich linear wachsend von 0,3 auf 0,7 msec |
| Beschichtungsdauer | 4 sec |
| Schichtdicke | 50 nm |
| Prozeßdruck | 0,5 mbar |
| Substrattemperatur | 70 °C |

Testergebnis:

Nach einer Lagerzeit von 24 h in saurer und 24 h in alkalischer Lösung besteht die Beschichtung den Tesatest und ist damit für den vorgesehenen Verwendungszweck geeignet.

Eine mit konstanter Impulsdauer von 0,3 ms bei sonst gleichen Beschichtungsparametern wie oben hergestellte Haftvermittlerschicht ist dagegen trüb und zerstört die Wellenleitung; eine mit konstanter Impulsdauer von 0,7 ms hergestellte Haftvermittlerschicht bei sonst gleichen Beschichtungsparametern führt dagegen zu einer schlechten Haftung der Beschichtung.

**Patentansprüche**

1. Plasma CVD-Verfahren zur Herstellung einer Gradientenschicht, bei welchem der Schichtgradient in Schichtwachstumsrichtung durch Änderung wenigstens eines Plasmaleistungsparameters während des Beschichtungsprozesses erzeugt wird,
   **dadurch gekennzeichnet,**
   daß die Plasmaleistung gepulst zugeführt wird (Plasma-Impuls-CVD-Verfahren) und der Schichtgradient durch Änderung der Plasmaleistungsparameter Impulshöhe, Impulsdauer und/oder Impulspause eingestellt wird.

2. Plasma-CVD-Verfahren nach Anspruch 1,
   **dadurch gekennzeichnet,**
   daß ein Gradient in der Schichtzusammensetzung eingestellt wird.

3. Plasma-CVD-Verfahren nach Anspruch 2,
   **dadurch gekennzeichnet,**
   daß in der Schicht ein Übergang organisch -> anorganisch erzeugt wird.

4. Plasma-CVD-Verfahren nach wenigstens einem der Ansprüche 1 bis 3,
   **dadurch gekennzeichnet,**
   daß ein Gradient in der Schichtstruktur eingestellt wird.

**5.** Plasma-CVD-Verfahren nach wenigstens einem der Ansprüche 1 bis 4,
**dadurch gekennzeichnet**,
daß die Schichtzusammensetzung und/oder Schichtstruktur so variiert werden, daß in der Schicht ein Gradient in einer oder mehreren der nachfolgenden Eigenschaften erzeugt wird: Härte, Benetzbarkeit, Brechzahl, Absorption, Dichte, Porosität, Kristallstruktur, Elastizitäts-Modul, elektrische Leitfähigkeit.

**6.** Plasma-CVD-Verfahren nach wenigstens einem der Ansprüche 1 bis 5,
**dadurch gekennzeichnet**,

daß ein Beschichtungsgas mit mehreren Schichtbildnern verwendet wird und
daß die Anteile der Schichtbildner in der niedergeschlagenen Schicht relativ zueinander durch Änderung der Plasmaleistungsparameter während des Beschichtungsprozesses variiert werden.

**7.** Plasma-CVD-Verfahren nach wenigstens einem der Ansprüche 1 bis 6,
**dadurch gekennzeichnet**,
daß zur Herstellung einer Kratzschutzschicht für Kunststoffbrillengläser eine Beschichtung aus einem Beschichtungsgas, das wenigstens einen metallorganischen Schichtbildner enthält, niedergeschlagen wird.

**8.** Plasma-CVD-Verfahren nach Anspruch 7,
**dadurch gekennzeichnet**,
daß als metallorganischer Schichtbildner HMDSO verwendet wird.

**9.** Plasma-CVD-Verfahren nach Anspruch 7 oder 8,
**dadurch gekennzeichnet**,
daß dem Beschichtungsgas noch Sauerstoff, Stickstoff und/oder ein Gas, das Sauerstoff und/oder Stickstoff im Plasma freisetzt, zugesetzt wird.

**10.** Plasma-CVD-Verfahren nach wenigstens einem der Ansprüche 1 bis 9,
**dadurch gekennzeichnet**,
daß das Plasma mittels Mikrowellenstrahlung angeregt wird.

**11.** Plasma-CVD-Verfahren nach Anspruch 10,
**dadurch gekennzeichnet**,
daß die Anregungsfrequenz der Mikrowellenstrahlung 2,45 GHz beträgt.

**12.** Plasma-CVD-Verfahren nach wenigstens einem der Ansprüche 1 bis 11,
**dadurch gekennzeichnet**,
daß der Schichtgradient durch Änderung der Impulsdauer während des Beschichtungsprozesses erzeugt wird.

**13.** Plasma-CVD-Verfahren nach Anspruch 12,
**dadurch gekennzeichnet**,
daß die Impulsdauer zwischen 0,1 und 2 msec variiert wird.

**14.** Plasma-CVD-Verfahren nach wenigstens einem der Ansprüche 1 bis 13,
**dadurch gekennzeichnet**,
daß während des Beschichtungsprozesses zusätzlich die Zusammensetzung des Beschichtungsgases geändert wird.

**Claims**

**1.** Plasma-CVD process for producing a gradient layer, in which the layer gradient in the direction of growth of the layer is generated during the coating process by varying at least one plasma power parameter, characterized in that the plasma power is supplied in pulses (pulsed plasma-CVD process) and the layer gradient is set by varying the plasma power parameters of pulse amplitude, pulse duration and/or interpulse period.

**2.** Plasma-CVD process according to Claim 1, characterized in that a gradient is set in the layer composition.

3. Plasma-CVD process according to Claim 2, characterized in that an organic → inorganic transition is generated in the layer.

4. Plasma-CVD process according to at least one of Claims 1 to 3, characterized in that a gradient is set in the layer structure.

5. Plasma-CVD process according to at least one of Claims 1 to 4, characterized in that the layer composition and/ or the layer structure are varied in such a way that a gradient in one or more of the following properties is generated in the layer: hardness, wettability, refractive index, absorption, density, porosity, crystal structure, modulus of elasticity, electrical conductivity.

6. Plasma-CVD process according to at least one of Claims 3 to 5, characterized in that a coating gas containing a plurality of layer precursors is used, and that the proportions of the layer precursors in the deposited layer are varied relative to one another by varying the plasma power parameters during the coating process.

7. Plasma-CVD process according to at least one of Claims 1 to 6, characterized in that, for producing an anti-scratch layer for plastic spectacle lenses, a coating is deposited from a coating gas which contains at least one metalorganic layer precursor.

8. Plasma-CVD process according to Claim 7, characterized in that HMDSO is used as the metalorganic layer precursor.

9. Plasma-CVD process according to Claim 7 or 8, characterized in that oxygen, nitrogen and/or a gas which releases oxygen and/or nitrogen in the plasma is also added to the coating gas.

10. Plasma-CVD process according to at least one of Claims 1 to 9, characterized in that the plasma is excited by means of microwave radiation.

11. Plasma-CVD process according to Claim 10, characterized in that the excitation frequency of the microwave radiation is 2.45 GHz.

12. Plasma-CVD process according to at least one of Claims 1 to 11, characterized in that the layer gradient is generated by varying the pulse duration during the coating process.

13. Plasma-CVD process according to Claim 12, characterized in that the pulse duration is varied between 0.1 and 2 milliseconds.

14. Plasma-CVD process according to at least one of Claims 1 to 13, characterized in that the composition of the coating gas is varied additionally during the coating process.

**Revendications**

1. Procédé CVD au plasma pour la fabrication d'une couche à gradient, dans lequel le gradient de la couche est produit, dans la direction de croissance de la couche, par la modification d'au moins un paramètre de puissance du plasma au cours du procédé de revêtement,
caractérisé en ce que
la puissance du plasma est amenée par impulsions (procédé CVD au plasma par impulsions) et en ce que le gradient de la couche est réglé par la modification des paramètres de la puissance du plasma amplitude de l'impulsion, durée de l'impulsion et/ou pause entre les impulsions.

2. Procédé CVD au plasma suivant la revendication 1,
caractérisé en ce que
un gradient est établi dans la composition de la couche.

3. Procédé CVD au plasma suivant la revendication 2,
caractérisé en ce que
une transition organique → inorganique est produite dans la couche.

**4.** Procédé CVD au plasma suivant l'une au moins des revendications 1 à 3,
caractérisé en ce que
un gradient est établi dans la structure de la couche.

**5.** Procédé CVD au plasma suivant l'une au moins des revendications 1 à 4,
caractérisé en ce que
la composition de la couche et/ou la structure de la couche varient de telle sorte qu'un gradient est produit dans la couche dans une ou plusieurs des propriétés suivantes : dureté, mouillabilité, indice de réfraction, absorption, densité, porosité, structure cristalline, module d'élasticité, conductivité électrique.

**6.** Procédé CVD au plasma suivant l'une au moins des revendications 1 à 5,
caractérisé en ce que

l'on utilise un gaz de revêtement contenant plusieurs agents filmogènes,
et que
la proportion de l'agent filmogène dans la couche déposée varie relativement par modification du paramètre de puissance du plasma au cours du processus de revêtement.

**7.** Procédé CVD au plasma suivant l'une au moins des revendications 1 à 6,
caractérisé en ce que
un revêtement est déposé à partir d'un gaz de revêtement, qui contient au moins un agent filmogène organométallique, pour la fabrication d'une couche de protection contre les rayures pour verres de lunettes en plastique.

**8.** Procédé CVD au plasma suivant la revendication 7,
caractérisé en ce que
l'on utilise du HMDSO comme agent filmogène organométallique.

**9.** Procédé CVD au plasma suivant la revendication 7 ou 8,
caractérisé en ce que
l'on ajoute encore au gaz de revêtement de l'oxygène, de l'azote et/ou un gaz qui libère de l'oxygène et/ou de l'azote dans le plasma.

**10.** Procédé CVD au plasma suivant l'une au moins des revendications 1 à 9,
caractérisé en ce que
le plasma est activé au moyen de micro-ondes.

**11.** Procédé CVD au plasma suivant la revendication 10,
caractérisé en ce que
la fréquence d'activation du rayonnement micro-ondes est de 2,45 GHz.

**12.** Procédé CVD au plasma suivant l'une au moins des revendications 1 à 11,
caractérisé en ce que
le gradient de la couche est produit par la modification de la durée des impulsions au cours du processus de revêtement.

**13.** Procédé CVD au plasma suivant la revendication 12,
caractérisé en ce que
la durée des impulsions varie entre 0,1 et 2 msec.

**14.** Procédé CVD au plasma suivant l'une au moins des revendications 1 à 13,
caractérisé en ce que
la composition des gaz de revêtement est en outre modifiée au cours du processus de revêtement.